# DEMANDE DE BREVET EUROPEEN

(11) **EP 4 391 078 A2**
(43) Date de publication de la demande: **26.06.2024**
(21) Numéro de dépôt: 23219521.4
(22) Date de dépôt: 21.12.2023
(51) Int. Cl.: H01L 29/66, H01L 29/78, H01L 29/786

(54) **DISPOSITIF MICROÉLECTRONIQUE FET COMPRENANT D'IMPORTANTES SURFACES DE CONTACT ENTRE LE CANAL DE CONDUCTION ET LES RÉGIONS DE SOURCE ET DRAIN**

(30) Priorité: 22.12.2022 FR 2214258
(71) Demandeur: Commissariat à l'énergie atomique et aux énergies alternatives, 75015 Paris (FR)
(72) Inventeur: BARRAUD, Sylvain, 38054 GRENOBLE CEDEX 09 (FR); COQUAND, Rémi, 38054 GRENOBLE CEDEX 09 (FR); REBOH, Shay, 38054 GRENOBLE CEDEX 09 (FR)
(74) Mandataire: Brevalex

(57) **Abrégé**

Dispositif microélectronique FET (100) comprenant :
- une couche de semi-conducteur (120) dont une première zone (122) forme un canal ;
- une grille (110) et une couche (112) de diélectrique de grille ou une couche mémoire ferroélectrique, disposés contre la première zone ;
- des espaceurs diélectriques (114) disposés contre des flancs de la grille ;
- des régions de source (116) / drain (118) couplées électriquement à la première zone par des deuxièmes zones (124) de la couche active s'étendant entre les régions de source / drain et les espaceurs diélectriques ;
dans lequel les deuxièmes zones forment, avec la première zone, une couche continue, et la première zone forme une portion semi-conductrice telle que la grille recouvre plusieurs faces distinctes de la portion semi-conductrice.

## Description

### DOMAINE TECHNIQUE

L'invention concerne le domaine des dispositifs microélectroniques appliqués aux technologies CMOS avancées. L'invention porte notamment sur des dispositifs microélectroniques de type FET (« Field-Effect Transistor » en anglais, ou transistor à effet de champ), notamment de type FinFET (« Fin Field-Effect Transistor » en anglais, ou transistor à effet de champ à ailettes) ou FeFET (« Ferroelectric Field Effect Transistor » en anglais, ou transistor ferroélectrique à effet de champ), en particulier à base de matériaux bidimensionnels, ou matériaux 2D, ou oxydes semi-conducteurs, ainsi que la réalisation de tels dispositifs microélectroniques.

### État de la technique antérieure

La miniaturisation de l'électronique est en constante augmentation, mais l'industrie approche désormais de la limite d'échelle pour les matériaux classiques tels que le silicium. Dernièrement, les matériaux 2D sont apparus comme des candidats prometteurs pour une utilisation dans les dispositifs électroniques et optoélectroniques miniaturisés en raison de leurs propriétés uniques et de la très faible épaisseur des couches de ces matériaux qui peuvent être constitués d'une seule couche d'atomes ou de molécules.

Le document de K. P. O'Brien et al., "Advancing 2D Monolayer CMOS Through Contact, Channel and Interface Engineering," 2021 IEEE International Electron Devices Meeting (IEDM), 2021, pp. 7.1.1-7.1.4, propose de réaliser un transistor MOSFET en intégrant une couche de MoS₂ pour former le canal de conduction. Cette couche est connectée à deux régions de source et drain métalliques à base d'or, de palladium, de TiN, de tungstène ou encore de nickel. La grille arrière est formée par une couche de silicium dopé positionnée en face arrière sous une couche de diélectrique à base de SiO₂, HfO₂ ou d'Al₂O₃.

Afin de s'affranchir des contraintes liées au dépôt des matériaux métalliques des régions de source et de drain sur le matériau 2D, il est possible de former ces régions non pas sur la face supérieure de la couche de matériau 2D, mais contre les flancs de la couche de matériau 2D. Cette configuration, appelée « side contact », est toutefois problématique car la surface de contact entre la couche de matériau 2D et les régions de source et de drain est faible, ce qui engendre d'importantes résistances de contact aux interfaces entre la couche de matériau 2D et les régions de source et de drain.

Le document US 2022/045176 A1 décrit plusieurs procédés de réalisation de transistors FET de type « gate-last », dans lesquels des portions de silicium servent de support pour le dépôt d'une couche de matériau 2D. Outre les inconvénients liés au fait que les transistors réalisés ont des interfaces canal / source-drain de type « side contact », les portions de silicium utilisées pour déposer le matériau 2D forment une barrière de potentiel à l'interface avec le matériau 2D, ce qui n'est pas favorable car une partie du transport des charges peut s'effectuer dans ces portions de silicium et non dans le matériau 2D.

### EXPOSÉ DE L'INVENTION

Un but de la présente invention est de proposer un dispositif microélectronique de type FET dont la structure soit compatible avec tout type de matériau semi-conducteur dont les matériaux 2D ou d'autres matériaux de type oxydes semiconducteurs, et ne présentant pas les inconvénients d'une configuration « side contact ».

Pour cela, la présente invention propose un dispositif microélectronique FET comprenant au moins :
- un substrat ;
- une couche de semi-conducteur comprenant au moins une première zone formant une portion semi-conductrice en forme d'ailette et servant de canal de conduction électrique du dispositif microélectronique FET ;
- une grille de commande électrostatique ;
- une couche de diélectrique de grille ou une couche mémoire ferroélectrique, disposée entre la grille de commande électrostatique et la première zone de la couche de semi-conducteur en recouvrant plusieurs faces distinctes de la première zone de la couche de semi-conducteur;
- des espaceurs diélectriques disposés contre des flancs de la grille de commande électrostatique ;
- des régions de source / drain en forme d'ailettes, couplées électriquement à la première zone de la couche de semi-conducteur par des deuxièmes zones de la couche de semi-conducteur, les deuxièmes zones de la couche de semi-conducteur s'étendant entre les régions de source / drain et les espaceurs diélectriques ;
et dans lequel les deuxièmes zones de la couche de semi-conducteur ne sont pas disposées directement contre la grille de commande électrostatique et forment, avec la première zone, une couche continue.

Le dispositif microélectronique proposé se base sur une architecture de type FET ne comportant pas d'interface de type « side contact » entre le canal et les régions de source / drain grâce aux deuxièmes zones de la couche de semi-conducteur réalisant le couplage électrique entre le canal formé par la première zone de la couche de semi-conducteur et les régions de source / drain. Ces deuxièmes zones de la couche de semi-conducteur, qui s'étendent contre au moins une partie des parois latérales, ou flancs, des régions de source / drain, forment une grande surface de contact avec régions de source / drain, ce qui permet de réduire les résistances de contact des régions de source / drain. Ainsi, le courant électrique circulant dans le canal n'est pas réduit à cause de ces résistances de contact, ce qui ne réduit pas les performances du dispositif.

De plus, avec l'architecture proposée, la couche de semi-conducteur peut être réalisée juste avant la réalisation des régions de source / drain ou juste avant le dépôt métallique des régions de source / drain. Ainsi, la couche de semi-conducteur dont la première zone est destinée à former le canal de conduction n'est pas détériorée par les étapes liées à la réalisation des régions de source / drain. Cela est particulièrement avantageux lorsque la couche de semi-conducteur comporte un matériau 2D.

En outre, la réalisation d'un tel dispositif ne nécessite pas de conserver des portions de silicium pour déposer la couche de semi-conducteur destinée à former le canal, supprimant ainsi le problème de barrière de potentiel à l'interface avec le matériau de la couche de semi-conducteur.

Lorsque le dispositif comporte la couche de diélectrique de grille, le dispositif peut correspondre à un transistor de type FinFET. Lorsque le dispositif comporte la couche mémoire ferroélectrique, le dispositif peut correspondre à un dispositif mémoire de type FeFET.

La couche de semi-conducteur peut comporter un matériau bidimensionnel ou tout autre matériau semi-conducteur déposé par exemple par MOCVD (« Metal Organic Chemical Vapor Déposition » en anglais, ou dépôt chimique en phase vapeur aux organométalliques), CVD (« Chemical Vapor Déposition » en anglais, ou dépôt chimique en phase valeur) ou ALD (« Atomic Layer Déposition » en anglais, ou dépôt en couche atomique). Dans ce cas, le dispositif microélectronique peut être réalisé avec de très faibles dimensions. La couche de semi-conducteur peut notamment comporter au moins un matériau 2D et/ou un matériau de type oxyde semiconducteur.

La grille de commande électrostatique et la couche de diélectrique de grille, ou la grille de commande électrostatique et la couche mémoire ferroélectrique, peuvent recouvrir ensemble plusieurs faces distinctes de la portion semi-conductrice.

De manière avantageuse, le dispositif microélectronique FET peut être tel que :
- chacune des régions de source / drain soit disposée dans une cavité comprenant des parois latérales formées au moins par les espaceurs diélectriques et par un matériau diélectrique d'isolation ;
- les deuxièmes zones de la couche de semi-conducteur recouvrent au moins une partie, et de préférence entièrement, des parois des cavités dans lesquelles sont disposées les régions de source / drain.

Dans la configuration ci-dessus, les surfaces de contact des régions de source / drain avec la couche de semi-conducteur sont maximisées grâce à l'utilisation de la surface des parois des cavités, et avantageusement l'ensemble de la surface des parois de la cavité, pour former le contact entre les deuxièmes zones de la couche de semi-conducteur et les régions de source / drain, ce qui permet d'avoir de très faibles résistances de contact des régions de source / drain, et donc un plus fort courant parcourant le canal de conduction du dispositif.

Le dispositif microélectronique FET peut comporter en outre au moins une portion diélectrique entourée par la première zone de la couche de semi-conducteur.

En variante, la première zone de la couche de semi-conducteur peut ne pas entourer de portion diélectrique.

La couche de semi-conducteur peut comporter plusieurs premières zones formant plusieurs portions semi-conductrices distinctes en forme d'ailettes, disposées sur le substrat et telles que la couche de diélectrique de grille ou la couche mémoire ferroélectrique soit disposée entre la grille de commande électrostatique et chacune des premières zones de la couche de semi-conducteur en recouvrant ensemble plusieurs faces distinctes de chacune des premières zones de la couche de semi-conducteur.

De manière avantageuse, l'invention peut s'appliquer pour la réalisation de composants CMOS pour les noeuds technologiques 5 nm et sub-5nm.

L'invention concerne également un procédé de réalisation d'un dispositif microélectronique FET, comprenant au moins :
a) réalisation d'au moins une portion de matériau temporaire sur un substrat, puis
b) réalisation, au moins sur la portion de matériau temporaire, d'au moins une grille de commande électrostatique et d'espaceurs diélectriques disposés contre des flancs de la grille de commande électrostatique, la grille de commande électrostatique recouvrant plusieurs faces distinctes de la portion de matériau temporaire, puis
c) gravure de la portion de matériau temporaire, puis
d) réalisation d'une couche de semi-conducteur comportant un matériau bidimensionnel ou tout autre matériau semi-conducteur déposé par MOCVD, CVD ou ALD, la couche de semi-conducteur comprenant au moins une première zone formant une portion semi-conductrice en forme d'ailette disposée sur le substrat et configurée pour servir de canal de conduction électrique du dispositif microélectronique FET, disposée sous la grille de commande électrostatique et les espaceurs diélectriques dans au moins un emplacement formé par la gravure de la portion de matériau temporaire, et telle que la couche de semi-conducteur se prolonge, sans discontinuité avec la première zone, en formant des deuxièmes zones couvrant au moins une partie des flancs des espaceurs diélectriques et qui ne sont pas disposées directement contre la grille de commande électrostatique, puis
e) réalisation, sur le substrat, de régions de source / drain en forme d'ailettes, couplées électriquement à la première zone de la couche de semi-conducteur par les deuxièmes zones de la couche de semi-conducteur, et telles que les deuxièmes zones de la couche de semi-conducteur s'étendent entre les régions de source / drain et les espaceurs diélectriques.

Le procédé peut comporter en outre, avant la mise en oeuvre de l'étape c), un dépôt d'un matériau diélectrique d'isolation autour des espaceurs diélectriques, puis une gravure de cavités dans le matériau diélectrique d'isolation telle que les cavités comprennent au moins une paroi latérale formée par l'un des espaceurs diélectriques, et dans lequel :
- l'étape d) est mise en oeuvre telle que les deuxièmes zones de la couche de semi-conducteur recouvrent au moins une partie des parois latérales des cavités ;
- l'étape e) est mise en oeuvre telle que chacune des régions de source / drain soit disposée dans une des cavités.

Dans une configuration avantageuse :
- l'étape a) peut comporter la réalisation de plusieurs portions de matériau temporaires sur le substrat, et
- l'étape b) peut être mise en oeuvre telle que la grille de commande électrostatique recouvre plusieurs faces distinctes de chacune des portions de matériau temporaires, et
- l'étape c) comporte la gravure de toutes les portions de matériau temporaires, et
- l'étape d) peut être mise en oeuvre telle que plusieurs premières zones de la couche de semi-conducteur soient disposées dans des emplacements formés par la gravure des portions de matériau temporaires, les premières zones de la couche de semi-conducteur formant plusieurs portions semi-conductrice disposées sur le substrat et telles que la grille de commande électrostatique recouvre plusieurs faces distinctes de chacune des premières zones de la couche de semi-conducteur.

Le procédé peut comporter en outre une étape de dépôt d'une couche de diélectrique de grille ou d'une couche mémoire ferroélectrique mise en oeuvre :
- entre les étapes a) et b), sur la portion de matériau temporaire, la grille de commande électrostatique étant réalisée ensuite sur la couche de diélectrique de grille ou la couche mémoire ferroélectrique, et/ou
- entre les étapes c) et d), sous la grille de commande électrostatique et les espaceurs diélectriques, dans au moins un emplacement formé par la gravure de la portion de matériau temporaire, la couche de semi-conducteur étant réalisée ensuite en recouvrant la couche de diélectrique de grille ou la couche mémoire ferroélectrique.

L'invention concerne également un procédé de réalisation d'un dispositif microélectronique FET, comprenant au moins :
a) réalisation d'au moins une portion de matériau temporaire sur un substrat, puis
b) réalisation, au moins sur la portion de matériau temporaire, d'au moins une grille temporaire et d'espaceurs diélectriques disposés contre des flancs de la grille temporaire, la grille temporaire recouvrant plusieurs faces distinctes de la portion de matériau temporaire, puis
c) gravure de la portion de matériau temporaire, puis
d) réalisation d'une couche de semi-conducteur comportant un matériau bidimensionnel ou tout autre matériau semi-conducteur déposé par MOCVD, CVD ou ALD, la couche de semi-conducteur comprenant au moins une première zone formant une portion semi-conductrice en forme d'ailette disposée sur le substrat et configurée pour servir de un canal de conduction électrique du dispositif microélectronique FET, disposée sous la grille temporaire et les espaceurs diélectriques dans au moins un emplacement formé par la gravure de la portion de matériau temporaire, et telle que la couche de semi-conducteur se prolonge, sans discontinuité avec la première zone, en formant des deuxièmes zones couvrant au moins une partie des flancs des espaceurs diélectriques et qui ne sont pas disposées directement contre la grille temporaire, puis
e) gravure de la grille temporaire, et réalisation d'au moins une grille de commande électrostatique à la place de la grille temporaire, puis
f) réalisation, sur le substrat, de régions de source / drain en forme d'ailettes, couplées électriquement à la première zone de la couche de semi-conducteur par les deuxièmes zones de la couche de semi-conducteur, et telles que des deuxièmes zones de la couche de semi-conducteur s'étendent entre les régions de source / drain et les espaceurs diélectriques.

Dans ce cas, le procédé peut comporter en outre, avant la mise en oeuvre de l'étape c), un dépôt d'un matériau diélectrique d'isolation autour des espaceurs diélectriques, puis une gravure de cavités dans le matériau diélectrique d'isolation telle que les cavités comprennent au moins une paroi latérale formée par l'un des espaceurs diélectriques, et dans lequel :
- l'étape d) est mise en oeuvre telle que les deuxièmes zones de la couche de semi-conducteur recouvrent au moins une partie des parois latérales des cavités ;
- l'étape f) est mise en oeuvre telle que chacune des régions de source / drain soit disposée dans une des cavités.

En outre, le procédé peut être tel que :
- l'étape a) comporte la réalisation de plusieurs portions de matériau temporaires sur le substrat, et
- l'étape b) est mise en oeuvre telle que la grille temporaire recouvre plusieurs faces distinctes de chacune des portions de matériau temporaires, et
- l'étape c) comporte la gravure de toutes les portions de matériau temporaires, et
- l'étape d) est mise en oeuvre telle que plusieurs premières zones de la couche de semi-conducteur soient disposées dans des emplacements formés par la gravure des portions de matériau temporaires, les premières zones de la couche de semi-conducteur formant plusieurs portions semi-conductrices disposées sur le substrat et telles que la grille temporaire recouvre plusieurs faces distinctes de chacune des premières zones de la couche de semi-conducteur.

Le procédé peut comporter en outre une étape de dépôt d'une couche de diélectrique de grille ou d'une couche mémoire ferroélectrique mise en oeuvre :
- lors de l'étape e), sur la première zone de la couche de semi-conducteur, la grille de commande électrostatique étant réalisée ensuite sur la couche de diélectrique de grille ou la couche mémoires ferroélectrique, et/ou
- entre les étapes c) et d), sous la grille temporaire et les espaceurs diélectriques, dans au moins un emplacement formé par la gravure de la portion de matériau temporaire, la couche de semi-conducteur étant réalisée ensuite en recouvrant la couche de diélectrique de grille ou la couche mémoire ferroélectrique.

Dans l'ensemble du document, les termes « sur » et « sous » sont utilisés sans distinction de l'orientation dans l'espace de l'élément auquel se rapporte ce terme. Par exemple, dans la caractéristique « sur une face du premier substrat », cette face du premier substrat n'est pas nécessairement orientée vers le haut mais peut correspondre à une face orientée selon n'importe quelle direction. En outre, la disposition d'un premier élément sur un deuxième élément doit être comprise comme pouvant correspondre à la disposition du premier élément directement contre le deuxième élément, sans aucun élément intermédiaire entre les premier et deuxième éléments, ou bien comme pouvant correspondre à la disposition du premier élément sur le deuxième élément avec un ou plusieurs éléments intermédiaires disposés entre les premier et deuxième éléments. Dans tout le document, le terme « couche » peut désigner une seule couche ou un empilement de plusieurs couches.

Dans l'ensemble du document, l'expression « coupler électriquement » est utilisée pour désigner une liaison électrique pouvant être directe ou pouvant être indirecte (c'est-à-dire réaliser à travers un ou plusieurs éléments électriques intermédiaires).

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- [Fig. 1] à [Fig. 6] représentent schématiquement les étapes d'un procédé de réalisation du dispositif microélectronique FET, objet de la présente invention, selon un mode de réalisation particulier ;
- [Fig. 7] représente schématiquement un dispositif microélectronique, objet de la présente invention, selon une variante du mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### Exposé détaillé de modes de réalisation particuliers

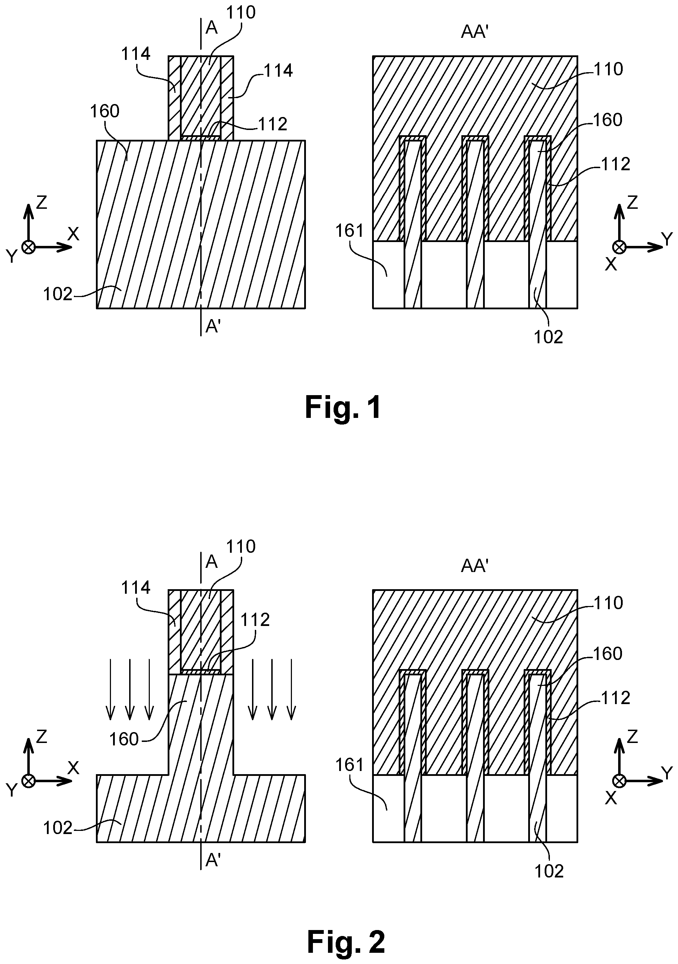

Un exemple de procédé de réalisation d'un dispositif microélectronique FET 100 selon un mode de réalisation particulier, correspondant à un dispositif FinFET, est décrit ci-dessous en lien avec les figures 1 à 6. Sur chacune de ces figures, la vue de gauche est une vue en coupe dans le plan (X,Z), et la vue de droite correspond à une vue en coupe selon l'axe AA' visible sur la vue de gauche.

Dans l'exemple de réalisation décrit en lien avec ces figures, le dispositif 100 est réalisé à partir d'un substrat 102 de type bulk. Le substrat 102 est gravé depuis sa face supérieure de manière à former, sur cette face, une ou plusieurs portions de matériau temporaires 160 dont la forme et le volume correspondent à ceux souhaités pour former la zone active du dispositif 100. Sur la figure 1, trois portions de matériau temporaires 160 sont représentées.

En variante, le substrat 102 peut correspondre à un substrat SOI, c'est-à-dire comprenant une couche superficielle de silicium disposée sur une couche diélectrique enterrée comprenant par exemple du SiO₂, la couche diélectrique enterrée étant disposée sur une couche support comprenant par exemple du silicium.

Une couche 112 de diélectrique de grille et une grille de commande électrostatique 110 sont ensuite réalisées et recouvrent plusieurs faces distinctes de chaque portion de matériau temporaire 160. Les flancs de la grille 110 sont recouverts par les espaceurs diélectriques 114. En outre, les portions 160 sont isolées électriquement par des régions d'isolation diélectriques 161 de type STI (« Shallow Trench Isolation » en anglais, ou tranchées d'isolation peu profondes) formées dans le substrat 104.

La couche 112 comporte par exemple un matériau diélectrique high-K (à forte permittivité diélectrique) tel que du HfO₂. En variante, cette couche 112 peut comporter du SiO₂ ou de l'Al₂O₃ ou tout autre matériau ou combinaison de matériaux adaptés.

La grille de commande électrostatique 110 est par exemple réalisée par dépôt d'un ou plusieurs matériaux conducteurs sur la couche 112, par exemple un premier dépôt d'une fine couche de TiN (épaisseur par exemple égale à 3 nm) sur laquelle est empilée une couche de tungstène d'épaisseur par exemple égale à 200 nm. En variante, la grille 110 peut comporter un ou plusieurs matériaux différents du TiN et du W, comme par exemple du polysilicium dopé ou tout autre métal (Mo, etc.).

En outre, un matériau adapté à la réalisation des espaceurs diélectriques 114 correspond par exemple à du SiN, du SiCO ou du SiBCN. L'épaisseur de la couche déposée pour réaliser les espaceurs diélectriques 114 est par exemple comprise entre 5 nm et 15 nm. Les portions 160 sont ensuite gravées de manière anisotrope afin de ne conserver que les parties de ces portions recouvertes par la grille 104 (voir figure 2). Cette gravure est stoppée sur les régions d'isolation 161.

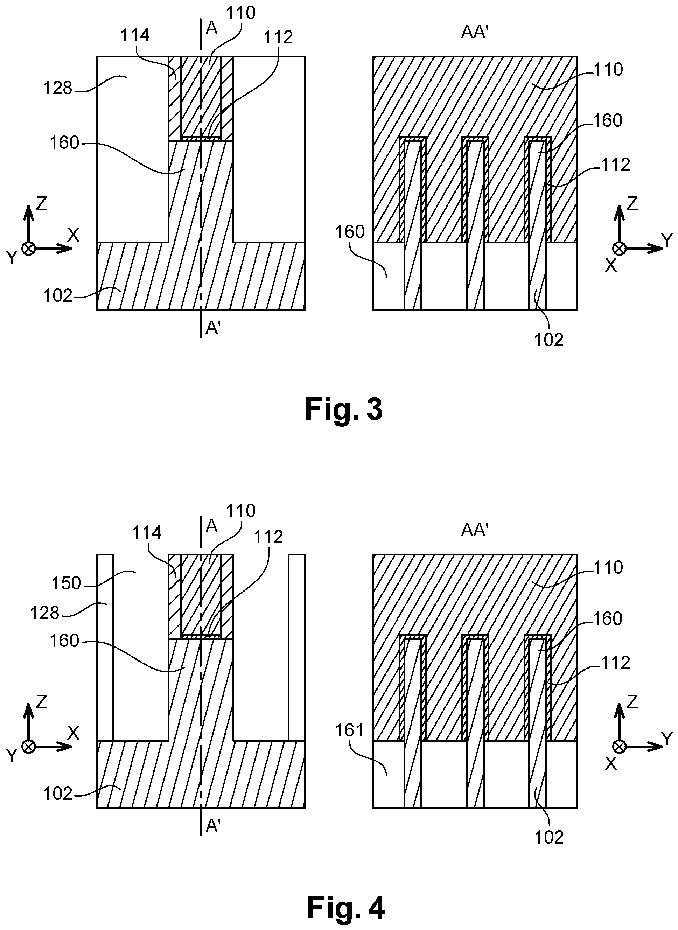

Un matériau diélectrique d'isolation 128, par exemple du SiO₂, est ensuite déposé puis planarisé avec arrêt sur le masque dur (non visible sur les figures). Le matériau diélectrique d'isolation 128 est déposé avec une forte épaisseur, puis une planarisation est mise en oeuvre jusqu'à atteindre le masque dur. Le masque dur est ensuite retiré par exemple par gravure humide, par exemple à l'aide d'une solution de H₃PO₄ diluée et utilisée à une température de 110°C. La structure obtenue à ce stade du procédé est représentée sur la figure 3. Des cavités 150 d'accueil sont ensuite formées. Ces cavités 150 forment des emplacements pour la réalisation des régions de source et de drain du dispositif 100.

La réalisation de ces cavités 150 peut comprendre ici la gravure du matériau diélectrique d'isolation 128 (voir figure 4). Les cavités 150 comprennent des parois latérales 150a qui, sont formées par les espaceurs diélectriques 114 et des portions restantes du matériau diélectrique d'isolation 128. Selon une variante de réalisation, le diélectrique d'isolation 128 est formé par un espaceur diélectrique d'un dispositif adjacent. Autrement dit, les cavités 150 peuvent être formées entre deux espaceurs diélectriques 114 de deux dispositifs adjacents de sorte à former un dispositif avec une électrode de source ou de drain partagée.

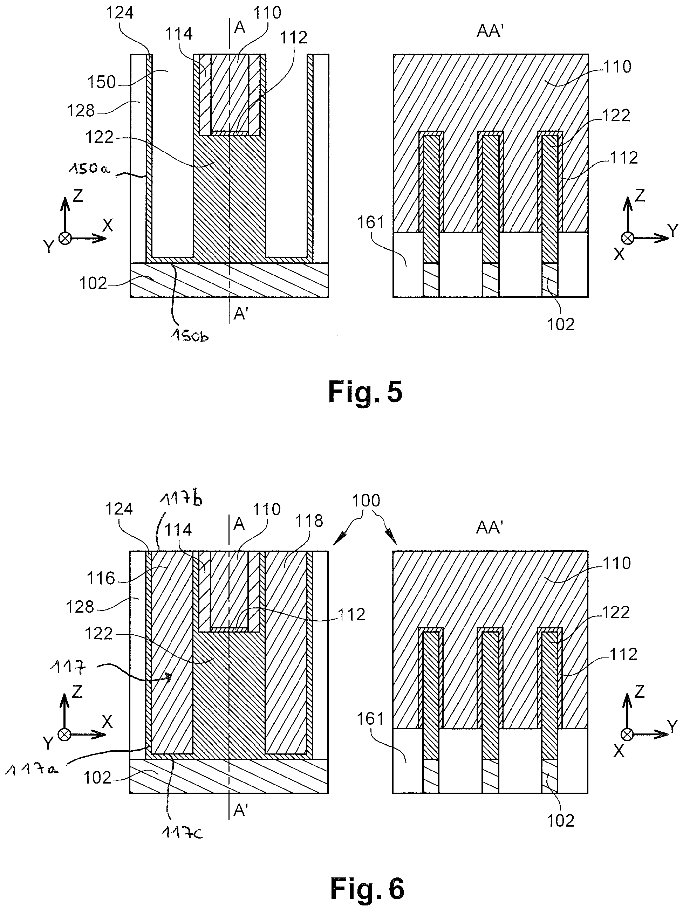

Les portions de matériau temporaires 160 sont ensuite gravées, puis une couche de semi-conducteur 120 est déposée (voir figure 5). Des premières zones 122 de la couche de semi-conducteur 120 forment des portions semi-conductrices en forme d'ailettes disposées sur le substrat 102 et occupant les espaces formés par la gravure des parties restantes des portions temporaires 160 localisées sous la grille 110. Les deuxièmes zones 124 de la couche de semi-conducteur 120 recouvrent ici entièrement les parois latérales 150a ainsi que le fond 150b des cavités 150. Les deuxièmes zones 124 peuvent former ou appartenir à des régions de source et de drain.

La couche de semi-conducteur 120 comporte au moins un matériau semi-conducteur 2D, par exemple un dichalcogénure de métaux de transition tel que du MoS₂, ou du WSe₂, ou du WS₂, ou du MoTe₂. Il est également possible que le matériau de la couche de semi-conducteur 120 corresponde à de l'IGZO, de l'In₂O₃, de l'IWO, de l'ITO, ou un oxyde de semi-conducteur amorphe, ou tout autre matériau semi-conducteur adapté déposé par CVD, MOCVD ou ALD.

Des contacts 117 de régions de source 116 et de drain 118, encore appelés contacts 117 de source 116 et de drain 118 sont ensuite réalisées dans les cavités 150 en déposant, dans l'exemple décrit, un ou plusieurs matériaux métalliques dans les cavités 150. Avant ce ou ces dépôts métalliques, il est possible de déposer une couche de graphène dans les cavités 150, ce ou ces métaux étant ensuite déposés sur la couche de graphène. Ces contacts 117 de source 116 et de drain 118, sur la figure 6, se retrouvent couplés électriquement aux premières zones 122 de la couche de semi-conducteur 120 par l'intermédiaire des deuxièmes zones 124 de la couche de semi-conducteur 120 qui s'étendent contre les espaceurs diélectriques 114 ainsi que contre les autres parois latérales des cavités 150. Les contacts 117 pour les régions de source 116 et de drain 118 sont ici avantageusement entièrement entourés par les deuxièmes zones 124 de la couche de semi-conducteur 120 au niveau de leurs flancs latéraux 117a et d'une portion d'extrémité inférieure 117b située au fond 150a de la cavité 150.

Le matériau de ces régions déposé en dehors des cavités 150 est supprimé par la mise en oeuvre d'une planarisation avec arrêt sur le matériau diélectrique d'isolation 128. Seule une portion d'extrémité 117c supérieure des contacts 117 S/D affleurant à une embouchure de la cavité 150 n'est pas entourée de la couche de matériau semi-conducteur 120.

De manière avantageuse, les régions de source 116 / drain 118 et/ou leurs contacts 117 comportent au moins un matériau métallique tel que de l'or, du palladium, du TiN, du W, du Ni, etc. Selon un exemple de réalisation, chacune des régions de source 116 / drain 118 et/ou leur contact 117 comporte une couche de TiN sur laquelle est formée une portion de tungstène. Différents métaux peuvent être utilisés pour former les régions 116, 118 et/ou leur contact 117 afin de favoriser de faibles résistances de contact, comme par exemple : S, Bi, Sn, Pd, Ru, Cu, Ni, Ti, TiN, W, Au, etc. Ces matériaux peuvent aussi être modifiés ultérieurement (pour améliorer leur propriétés), par une étape de dopage par exemple. Le dispositif 100 obtenu est visible sur la figure 6.

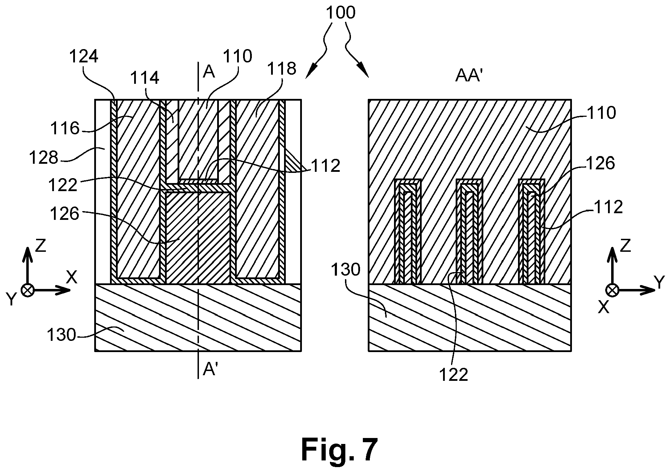

Dans l'exemple de réalisation précédemment décrit, la couche de semi-conducteur 120 est telle que l'espace précédemment occupé par la ou les portions temporaires 160 est totalement rempli par le matériau de la couche de semi-conducteur 120. En variante, il est possible que la couche de semi-conducteur 120 ne remplisse pas complètement le ou les espaces précédemment occupés par la ou les portions temporaires 160. Dans ce cas, après le dépôt de la couche de semi-conducteur 120, le ou les espaces restants sont remplis par du matériau diélectrique de manière à former une ou plusieurs portions diélectriques 126 (visibles sur l'exemple de la figure 7 décrit ci-dessous) entourées par la première zone 122 de la couche de semi-conducteur 120. Pour former cette ou ces portions 126, une ou plusieurs couches diélectriques, comprenant par exemple de l'Al₂O₃ (ou du HfO₂) et/ou du SiO₂ (ou un diélectrique low-k, ou à faible permittivité diélectrique), sont déposées puis gravées de manière isotrope afin de ne conserver que des portions 126 localisées dans les espaces restants.

Selon une autre variante, le substrat 102 peut être de type semi-conducteur sur isolant, par exemple SOI. Les portions temporaires 160 sont dans ce cas réalisées à partir de la couche superficielle de semi-conducteur du substrat 102. Les étapes mises en oeuvre pour réaliser le dispositif 100 sont similaires à celles précédemment décrites en lien avec les figures 1 à 6 (excepté les régions d'isolation 161 qui n'ont pas à être réalisées dans cette variante). Le dispositif 100 obtenu selon cette variante de réalisation est visible sur la figure 7.

Dans les différents exemples précédemment décrits, les deuxièmes zones 124 de la couche de semi-conducteur 120 recouvrent tous les flancs et les parois de fond des contacts 117 de source 116 et de drain 118. D'une manière générale, il est possible que les deuxièmes zones 124 de la couche de semi-conducteur 120 s'étendent entre les contacts de source 116 et de drain 118 et les espaceurs diélectriques 114 et/ou contre des parois des contacts 117 de source 116 et de drain 118 différentes de celles disposées contre les espaceurs diélectriques 114. En outre, les parois des contacts 117 de régions de source 116 et de drain 118 peuvent n'être recouvertes que partiellement par les deuxièmes zones 124 de la couche de semi-conducteur 120.

Dans les exemples de réalisation précédemment décrits pour les premier et deuxième modes de réalisation, la couche 112 de diélectrique de grille et la ou les grilles de commande électrostatique 110 sont réalisés sur la ou les portions de matériau temporaires 160 avant la réalisation de la couche de semi-conducteur 120 (approche dite « gate first »). En variante, il est possible de réaliser, à la place de la couche 112 de diélectrique de grille et de la ou des grilles de commande électrostatique 110, une ou plusieurs grilles temporaires sur la ou les portions de matériau temporaires 160, puis, après la réalisation de la couche de semi-conducteur 120, de graver la ou les grilles temporaires et de réaliser la couche 112 de diélectrique de grille et la ou les grilles de commande électrostatique 110 à la place de la ou des grilles temporaires gravées (approche dite « gate last »).

Dans les exemples de réalisation précédemment décrits, la couche 112 de diélectrique de grille est réalisée juste avant la réalisation de la ou des grilles de commande électrostatique 110, qu'une ou plusieurs grilles temporaires aient été utilisées ou non. En variante, il est possible que la ou les grilles de commande électrostatique 110 soient réalisées sans avoir réalisé au préalable la couche 112 de diélectrique de grille. Dans ce cas, la couche 112 de diélectrique de grille peut être déposée juste avant le dépôt de la couche de semi-conducteur 120, au moins contre les parois du ou des emplacements obtenus en gravant la ou les portions de matériau temporaire 160. Dans ce cas, la couche 112 vient recouvrir les différentes parois sur lesquelles le matériau de la couche de semi-conducteur 120 est destiné à être déposé, homogénéisant ainsi les surfaces, et donc les interfaces, contre lesquelles la couche de semi-conducteur 120 est ensuite déposée. Selon une autre variante, il est possible que la couche 112 soit déposée lors de deux étapes différentes : tout d'abord juste avant la réalisation de grille 110 comme précédemment décrit en lien avec la figure 1, puis dans les espaces formés par la gravure des portions 160 et dans les cavités 150, juste avant le dépôt de la couche de semi-conducteur 120. Dans ce cas, les parties de la couche 112 localisées à l'aplomb de la grille 110 sont plus épaisses que les autres parties de la couche 112 car ces parties cumulent les épaisseurs de matériau déposées au cours des deux étapes de dépôt.

Dans les exemples et variantes précédemment décrits, la couche 112 comporte un matériau diélectrique destiné à forme les diélectriques de grille des dispositifs 100 réalisés qui correspondent à des transistors FinFET. En variante, il est possible que la couche 112 comporte un matériau ferroélectrique tel que du HfO₂ ou HfZrO₂, cette couche 112 correspondant dans ce cas à une couche mémoire ferroélectrique. Les dispositifs 100 réalisés correspondent à des dispositifs microélectroniques ayant une fonction mémoire de type FeFET. Les différentes variantes de réalisation de la couche 112 précédemment décrites s'appliquent également à une couche 112 comportant un matériau ferroélectrique. En outre, lorsque la couche 112 comporte un matériau ferroélectrique, il est avantageux que la couche 112 soit déposée dans les espaces formés par la gravure des portions 160 et dans les cavités 150, juste avant le dépôt de la couche de semi-conducteur 120, ou déposée lors de deux étapes différentes comme précédemment décrit. Ainsi, la surface de matériau ferroélectrique formée par la couche 112 est plus importante que si elle était déposée uniquement juste avant la réalisation de la grille 110, ce qui réduit la variabilité de la mémoire en termes de performance.

## Revendications

1. Dispositif microélectronique FET (100) comprenant au moins :
- un substrat (102) ;
- une couche de semi-conducteur (120) comprenant au moins une première zone (122) formant une portion semi-conductrice en forme d'ailette et servant de canal de conduction électrique du dispositif microélectronique FET (100) ;
- une grille de commande électrostatique (110) ;
- une couche (112) de diélectrique de grille ou une couche (112) mémoire ferroélectrique, disposée entre la grille de commande électrostatique (110) et la première zone (122) de la couche de semi-conducteur (120) en recouvrant plusieurs faces distinctes de la première zone (122) de la couche de semi-conducteur (120) ;
- des espaceurs diélectriques (114) disposés contre des flancs de la grille de commande électrostatique (110) ;
- des régions de source (116) / drain (118) formées par des deuxièmes zones (124) de la couche de semi-conducteur (120), couplées électriquement à la première zone (122) de la couche de semi-conducteur (120) par les deuxièmes zones (124) de la couche de semi-conducteur (120), les deuxièmes zones (124) de la couche de semi-conducteur (120) s'étendant entre des contacts (117) de source (116) / drain (118) et les espaceurs diélectriques (114) ;
dans lequel les deuxièmes zones (124) de la couche de semi-conducteur (120) ne sont pas disposées directement contre la grille de commande électrostatique (110) et forment, avec la première zone (122), une couche continue ;
et dans lequel la couche de semi-conducteur (120) comporte un matériau bidimensionnel,
- chacune des régions de source (116) / drain (118) étant dotée d'un contact (117) de source /drain, avantageusement métallique, disposé dans une cavité (150), la cavité (150) comprenant des parois latérales (150b) et un fond (150a), les deuxièmes zones (124) de la couche de semi-conducteur (120) recouvrant entièrement les parois latérales (150b) et le fond (150a de la cavité (150), de sorte que des flancs latéraux (117a) et une portion d'extrémité inférieure (117b) dudit contact (117) sont entièrement entourés par les deuxièmes zones (124) de la couche de semi-conducteur (120) dans la cavité (150).

2. Dispositif microélectronique FET (100) selon la revendication 1, dans lequel la grille de commande électrostatique (110) et la couche (112) de diélectrique de grille recouvrent ensemble plusieurs faces distinctes de la portion semi-conductrice.

3. Dispositif microélectronique FET (100) selon l'une des revendications précédentes, dans lequel : chaque cavité (150) est formée au moins par les espaceurs diélectriques (114) et par un matériau diélectrique d'isolation (128) ;

4. Dispositif microélectronique FET (100) selon l'une des revendications précédentes, comportant en outre au moins une portion diélectrique entourée par la première zone (122) de la couche de semi-conducteur (120).

5. Dispositif microélectronique FET (100) selon l'une des revendications précédentes, dans lequel la couche de semi-conducteur (120) comporte plusieurs premières zones (122) formant plusieurs portions semi-conductrices distinctes en forme d'ailettes, disposées sur le substrat (102) et telles que la couche (112) de diélectrique de grille ou la couche (112) mémoire ferroélectrique soit disposée entre la grille de commande électrostatique (110) et chacune des premières zones (122) de la couche de semi-conducteur (120) en recouvrant plusieurs faces distinctes de chacune des premières zones (122) de la couche de semi-conducteur (120).

6. Procédé de réalisation d'un dispositif microélectronique FET (100), comprenant au moins :
a) réalisation d'au moins une portion de matériau temporaire (160) sur un substrat (102), puis
b) réalisation, au moins sur la portion de matériau temporaire (160), d'au moins une grille, la grille étant une grille de commande électrostatique (110) ou une grille temporaire et d'espaceurs diélectriques (114) disposés contre des flancs de la grille, la grille recouvrant plusieurs faces distinctes de la portion de matériau temporaire (160), puis
c) gravure de la portion de matériau temporaire (160), puis
d) réalisation d'une couche de semi-conducteur (120) comportant un matériau bidimensionnel ou tout autre matériau semi-conducteur déposé par MOCVD, CVD ou ALD, la couche de semi-conducteur (120) comprenant au moins une première zone (122) formant une portion semi-conductrice en forme d'ailette disposée sur le substrat (102) et configurée pour servir de canal de conduction électrique du dispositif microélectronique FET (100), disposée sous la grille (110) et les espaceurs diélectriques (114) dans au moins un emplacement formé par la gravure de la portion de matériau temporaire (160), et telle que la couche de semi-conducteur (120) se prolonge, sans discontinuité avec la première zone (122), en formant des deuxièmes zones (124) couvrant au moins une partie des flancs des espaceurs diélectriques (114) et qui ne sont pas disposées directement contre la grille (110), puis
e) réalisation, sur le substrat (102), de contacts de régions de source (116) / drain (118), couplés électriquement à la première zone (122) de la couche de semi-conducteur (120) par les deuxièmes zones (124) de la couche de semi-conducteur (120), et telles que des deuxièmes zones (124) de la couche de semi-conducteur (120) s'étendent entre les régions de source (116) / drain (118) et les espaceurs diélectriques (114).

7. Procédé selon la revendication 6, dans lequel la grille formée à l'étape b) est une grille de commande électrostatique (130), le procédé comportant en outre, avant la mise en oeuvre de l'étape c), un dépôt d'un matériau diélectrique d'isolation (128) autour des espaceurs diélectriques (114), puis une gravure de cavités (150) dans le matériau diélectrique d'isolation (128) telle que les cavités (150) comprennent au moins une paroi latérale formée par l'un des espaceurs diélectriques (114), et dans lequel :
- l'étape d) est mise en oeuvre telle que les deuxièmes zones (124) de la couche de semi-conducteur (120) recouvrent au moins une partie des parois latérales des cavités (150) ;
- l'étape e) est mise en oeuvre telle que chacune des régions de source (116) / drain (118) soit disposée dans une des cavités (150).

8. Procédé selon l'une des revendications 6 ou 7, dans lequel la grille formée à l'étape b) est une grille de commande électrostatique (130) et dans lequel :
- l'étape a) comporte la réalisation de plusieurs portions de matériau temporaires (160) sur le substrat (102), et
- l'étape b) est mise en oeuvre telle que la grille de commande électrostatique (110) recouvre plusieurs faces distinctes de chacune des portions de matériau temporaires (160), et
- l'étape c) comporte la gravure de toutes les portions de matériau temporaires (160), et
- l'étape d) est mise en oeuvre telle que plusieurs premières zones (122) de la couche de semi-conducteur (120) soient disposées dans des emplacements formés par la gravure des portions de matériau temporaires (160), les premières zones (122) de la couche de semi-conducteur (120) formant plusieurs portions semi-conductrice disposées sur le substrat (102) et telles que la grille de commande électrostatique (110) recouvre plusieurs faces distinctes de chacune des premières zones (122) de la couche de semi-conducteur (120).

9. Procédé selon l'une des revendications 6 à 8, dans lequel la grille formée à l'étape b) est une grille de commande électrostatique (130) comportant en outre une étape de dépôt d'une couche (112) de diélectrique de grille ou d'une couche (112) mémoire ferroélectrique mise en oeuvre :
- entre les étapes a) et b), sur la portion de matériau temporaire (160), la grille de commande électrostatique (110) étant réalisée ensuite sur la couche (112) de diélectrique de grille ou la couche (112) mémoire ferroélectrique, et/ou
- entre les étapes c) et d), sous la grille de commande électrostatique (110) et les espaceurs diélectriques (114), dans au moins un emplacement formé par la gravure de la portion de matériau temporaire (160), la couche de semi-conducteur (120) étant réalisée ensuite en recouvrant la couche (112) de diélectrique de grille ou la couche (112) mémoire ferroélectrique.

10. Procédé de réalisation d'un dispositif microélectronique FET (100) selon la revendication 6, dans lequel la grille réalisée à l'étape b) est une grille temporaire et dans lequel après l'étape b) et avant l'étape e), on effectue une gravure de la grille temporaire, et on réalise une grille de commande électrostatique (110) à la place de la grille temporaire.

11. Procédé selon la revendication 10, comportant en outre, avant la mise en oeuvre de l'étape c), un dépôt d'un matériau diélectrique d'isolation (128) autour des espaceurs diélectriques (114), puis une gravure de cavités (150) dans le matériau diélectrique d'isolation (128) telle que les cavités (150) comprennent au moins une paroi latérale formée par l'un des espaceurs diélectriques (114), et dans lequel :
- l'étape d) est mise en oeuvre telle que les deuxièmes zones (124) de la couche de semi-conducteur (120) recouvrent au moins une partie des parois latérales des cavités (150) ;
- l'étape e) est mise en oeuvre telle que chacune des régions de source (116) / drain (118) soit disposée dans une des cavités (150).

12. Procédé selon l'une des revendications 9 ou 10, dans lequel :
- l'étape a) comporte la réalisation de plusieurs portions de matériau temporaire (160) sur le substrat (102), et
- l'étape b) est mise en oeuvre telle que la grille temporaire recouvre plusieurs faces distinctes de chacune des portions de matériau temporaire (160), et
- l'étape c) comporte la gravure de toutes les portions de matériau temporaires (160), et
- l'étape d) est mise en oeuvre telle que plusieurs premières zones (122) de la couche de semi-conducteur (120) soient disposées dans des emplacements formés par la gravure des portions de matériau temporaires (160), les premières zones (122) de la couche de semi-conducteur (120) formant plusieurs portions semi-conductrices disposées sur le substrat (102) et telles que la grille temporaire recouvre plusieurs faces distinctes de chacune des premières zones (122) de la couche de semi-conducteur (120).

13. Procédé selon l'une des revendications 10 à 12, comportant en outre une étape de dépôt d'une couche (112) de diélectrique de grille ou d'une couche (112) mémoire ferroélectrique mise en oeuvre :
- lors de l'étape e), sur la première zone (122) de la couche de semi-conducteur (120), la grille de commande électrostatique (110) étant réalisée ensuite sur la couche (112) de diélectrique de grille ou la couche (112) mémoire ferroélectrique, et/ou
- entre les étapes c) et d), sous la grille temporaire et les espaceurs diélectriques (114), dans au moins un emplacement formé par la gravure de la portion de matériau temporaire (160), la couche de semi-conducteur (120) étant réalisée ensuite en recouvrant la couche (112) de diélectrique de grille ou la couche (112) mémoire ferroélectrique.

14. Procédé selon l'une des revendications 6 à 13, comprenant en outre, préalablement à la réalisation de la grille de commande électrostatique (110), la formation d'une couche (112) de diélectrique de grille ou d'une couche (112) mémoire ferroélectrique, la grille de commande électrostatique (110) étant déposée sur la couche (112) de diélectrique de grille ou sur la couche (112) mémoire ferroélectrique.

15. Procédé selon l'une des revendications 6 à 14, dans lequel :
la formation des régions de source (116) / drain (118) à l'étape e) comprend la réalisation de contacts (117) disposés chacun dans une cavité (150), la cavité (150) comprenant des parois latérales (150a) et un fond (150b), les deuxièmes zones (124) de la couche de semi-conducteur (120) recouvrant entièrement les parois latérales (150a) et le fond (150b) de la cavité (150), de sorte que, lesdits contacts (117) sont entièrement entourés par les deuxièmes zones (124) de la couche de semi-conducteur (120) dans leurs cavités (150) respectives.

16. Procédé selon la revendication 15, dans lequel les parois latérales (150a) des cavités (150a) sont formées partiellement par un espaceur diélectrique (114) et partiellement par un matériau diélectrique d'isolation (128) ;
